# EUROPEAN PATENT APPLICATION

(11) **EP 3 534 167 A1**
(43) Date of publication of application: **04.09.2019**
(21) Application number: 17865486.9
(22) Date of filing: 17.04.2017
(51) Int. Cl.: G01R 31/02

(54) **METHOD AND DEVICE FOR DETECTING CHARGING ABNORMALITY AND POWER ADAPTER**

(30) Priority: 26.10.2016 CN 201610952425
(71) Applicant: ZTE Corporation, Shenzhen, Guangdong 518057 (CN)
(72) Inventor: XIAO, Hua, Shenzhen Guangdong 518057 (CN)
(74) Representative: Regimbeau
(86) International application number: PCT/CN2017/080752
(87) International publication number: WO 2018/076623

(57) **Abstract**

Provided are a method and device for detecting a charging abnormality, and a power adapter. The method includes: detecting (101) a value of a detection current in a current detection circuit when it is detected that an output port is connected to a terminal and is in a charging state, where the current detection circuit is connected in series between an output end of a power converter and a power line of the output port; and transmitting (102) the value of the detection current to the terminal through the output port to allow the terminal to determine, according to the detection current, whether charging is abnormal.

## Description

### TECHNICAL FIELD

The present application relates to, but is not limited to, the field of communications and, in particular, relates to a method and device for detecting a charging abnormality, and a power adapter.

### BACKGROUND

In a long-term mobile phone development, it has been found that some of the reasons for customer return are due to a short-circuit burnout of the Universal Serial Bus (USB) port of a mobile phone and a slow charging of the mobile phone due to a partial electric leakage from the peripheral circuit of the charging circuit of the mobile phone. A light short circuit or a light electric leakage of the charging circuit causes failure to charge the mobile phone or causes slow charging of the mobile phone. A heavy short circuit or a heavy electric leakage of the charging circuit may cause a greater disaster such as a fire disaster. However, the detection and protection scheme of the charging circuit of the mobile phone is usually a detection and protection scheme for a battery abnormality, such as temperature protection, overcurrent protection, overcharge protection and overdischarge protection. A charging chip generally has protection and detection measures such as temperature protection.

### SUMMARY

The following is the summary of the subject matter described herein in detail. This summary is not intended to limit the scope of the claims.

A mobile phone suffers lack of a detection scheme for a charging abnormality like a short circuit or an electric leakage of the peripheral circuit of the charging circuit of the mobile phone such as a USB connector, an electrostatic discharge (ESD) protection circuit and a surge protection circuit. In the case of the short circuit or the electric leakage of the peripheral circuit, it is impossible to timely notify a user to stop charging and take actions to avoid risks.

In view of this, a method and device for detecting a charging abnormality, and a power adapter are provided in embodiments of the present disclosure to detect a charging abnormality like a short circuit or an electric leakage of a peripheral circuit.

A method for detecting a charging abnormality is provided in an embodiment of the present disclosure. The method includes:
detecting a value of a detection current in a current detection circuit when it is detected that an output PORT is connected to a terminal and is in a charging state, where the current detection circuit is connected in series between an output end of a power converter and a power line of the output port; and
transmitting the value of the detection current to the terminal through the output port to allow the terminal to determine, according to the detection current, whether charging is abnormal.

In the preceding solution, the detecting a value of a detection current in a current detection circuit includes:
detecting voltages at two ends of a current detection resistor in the current detection circuit by an analog-to-digital converter in the current detection circuit to obtain a first voltage value and a second voltage value;
obtaining a detection voltage value of the current detection resistor according to the first voltage value and the second voltage; and
obtaining the value of the detection current according to the detection voltage value and a resistance of the current detection resistor.

In the preceding solution, the detecting voltages at two ends of a current detection resistor in the current detection circuit by an analog-to-digital converter in the current detection circuit to obtain a first voltage value and a second voltage value includes:
collecting the voltages at the two ends of the current detection resistor by the analog-to-digital converter to obtain a first voltage and a second voltage; and
performing an analog-to-digital conversion on the first voltage to obtain the first voltage value, and performing an analog-to-digital conversion on the second voltage to obtain the second voltage value.

In the preceding solution, the transmitting the value of the detection current to the terminal through the output port includes:
transmitting the detection current in a form of data to the terminal by a data negative signal line and a data positive signal line of the output port.

A method for detecting a charging abnormality is provided in an embodiment of the present disclosure. The method includes:
acquiring a charging current value received from a charging port when it is detected that the charging port is connected to a power adapter and is being charged;
receiving a value of a detection current transmitted from the power adapter; and
determining that charging is abnormal when the charging current value does not match the value of the detection current.

In the preceding solution, after the receiving a value of a detection current transmitted from the power adapter, the method further includes:
comparing the charging current value with the value of the detection current; and
determining that the charging current value does not match the value of the detection current when a current difference exists between the charging current value and the value of the detection current.

In the preceding solution, before the acquiring a charging current value received from a charging port, the method further includes: setting a threshold of the current difference; and the determining that the charging current value does not match the value of the detection current includes:
determining that the charging current value does not match the value of the detection current when the current difference is greater than the threshold of the current difference.

In the preceding solution, after the determining that the charging is abnormal, the method further includes:
triggering a charging stop instruction to instruct to stop being charged.

A power adapter is provided in an embodiment of the present disclosure. The power adapter includes an output port, a power converter, a current detection circuit and a micro-control unit (MCU), where the current detection circuit is connected in series between a power line of the output port and an output end of the power converter, and the MCU is electrically connected to the current detection circuit.

In the preceding solution, when the output port is connected to a terminal and is in a charging state, the MCU detects a value of a detection current in the current detection circuit and transmits the value of the detection current to the terminal through the output port to allow the terminal to determine, according to the detection current, whether charging is abnormal.

In the preceding solution, the current detection circuit includes a current detection resistor and an analog-to-digital converter, where a first port of the analog-to-digital converter is connected to one of two ends of the current detection resistor and a second port of the analog-to-digital converter is connected to another one of the two ends of the current detection resistor.

In the preceding solution, the analog-to-digital converter collects voltage values at the two ends of the current detection resistor by the first port and the second port to obtain a first voltage value and a second voltage value; and

the MCU obtains a detection voltage value of the current detection resistor according to the first voltage value and the second voltage; and obtains the value of the detection current according to the detection voltage value and a resistance of the current detection resistor.

In the preceding solution, the analog-to-digital converter is configured to:
collect the voltages at the two ends of the current detection resistor to obtain a first voltage and a second voltage; and
perform an analog-to-digital conversion on the first voltage to obtain the first voltage value, perform an analog-to-digital conversion on the second voltage to obtain the second voltage value, and transmit the first voltage value and the second voltage value to the MCU.

In the preceding solution, the MCU is connected to a data negative signal line and a data positive signal line of the output port; and the MCU transmits the detection current in a form of data to the terminal by the data negative signal line and the data positive signal line.

A device for detecting a charging abnormality is provided in an embodiment of the present disclosure. The device includes: an acquiring module, a receiving module and a determining module.

The Acquiring module is configured to acquire a charging current value received from a charging port when it is detected that the charging port is connected to a power adapter and is being charged.

The receiving module is configured to receive a value of detection current transmitted from the power adapter.

The determining module is configured to determine that charging is abnormal when the charging current value does not match the value of the detection current.

In the preceding solution, the device further includes a comparison module, which is configured to:
compare the charging current value with the value of the detection current; and
determine that the charging current value does not match the value of the detection current when a current difference exists between the charging current value and the value of the detection current.

In the preceding solution, the device further includes a setting module, which is configured to set a threshold of the current difference, where the comparison module is configured to:
determine that the charging current value does not match the value of the detection current when the current difference is greater than the threshold of the current difference.

In the preceding solution, the device further includes a control module, which is configured to trigger, after it is determined that the charging is abnormal, a charging stop instruction to instruct to stop being charged.

A computer-readable storage medium is provided in an embodiment of the present disclosure. The storage medium is configured to store computer-executable instructions. When the computer-executable instructions are executed by a processor, the preceding method for detecting a charging abnormality is implemented.

A method and device for detecting a charging abnormality, and a power adapter are provided in embodiments of the present disclosure. The method includes detecting a value of a detection current in a current detection circuit when it is detected that an output end is connected to a terminal and is in a charging state, where the current detection circuit is connected in series between an output end of a power converter and a power line of the output port; and transmitting the value of the detection current to the terminal through the output port to allow the terminal to determine, according to the detection current, whether charging is abnormal. A terminal acquires a charging current value received from a charging port when it is detected that the charging port is connected to a power adapter and is in a charging state; receives a value of a detection current transmitted by the power adapter; and determines that charging is abnormal when the charging current value does not match the value of the detection current. In this way, when the power adapter is in the charging state, the magnitude of the current value transmitted by the power adapter to the terminal is determined according to the value of the detection current of the current detection circuit connected between the output end of the power converter and the power line of the output port, and whether the terminal is in a charging abnormality state is determined according to the magnitude of the current value. When the terminal receives the value of the detection current and determines that the value of the detection current does not match the magnitude of the charging current, it is determined that the terminal is in the charging abnormality state. In this solution, the charging abnormality of the terminal is detected without modification of hardware of the terminal, avoiding further faults and losses arising from a charging abnormality such as a power leakage after a USB connector or the like is short-circuited.

Other aspects can be understood after the accompanying drawings and detailed description are read and understood.

### BRIEF DESCRIPTION OF DRAWINGS

FIG. 1 is a flowchart of a method for detecting a charging abnormality according to embodiment one of the present disclosure;
FIG. 2 is a flowchart of a method for detecting a charging abnormality according to embodiment two of the present disclosure;
FIG. 3 is a flowchart of a method for detecting a charging abnormality according to embodiment three of the present disclosure;
FIG. 4 is a structure diagram of a power adapter according to embodiment four of the present disclosure;
FIG. 5 is a structure diagram of another power adapter according to embodiment four of the present disclosure;
FIG. 6 is a structure diagram of a device for detecting a charging abnormality according to embodiment five of the present disclosure;
FIG. 7 is a structure diagram of another device for detecting a charging abnormality according to embodiment five of the present disclosure; and
FIG. 8 is a structure diagram of a system device for detecting a charging abnormality according to embodiment seven of the present disclosure.

### DETAILED DESCRIPTION

The implementation of the solutions is described below with reference to the accompanying drawings.

### Embodiment one

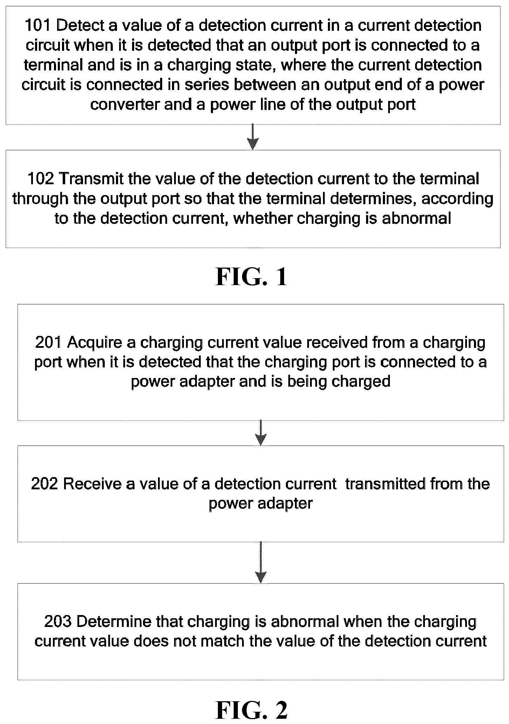

A method for detecting a charging abnormality is provided in embodiment one of the present disclosure. The method is applicable to a power adapter. As shown in FIG. 1, the method includes steps described below.

In step S101, a value of a detection current in a current detection circuit is detected when it is detected that an output port is connected to a terminal and is in a charging state, where the current detection circuit is connected in series between an output end of a power converter and a power line of the output port.

Herein, when the power adapter detects that the output port thereof is connected to a USB cable, and further connected to a terminal through the USB cable and charges the connected terminal, it is determined that the output port is connected to the terminal and is in the charging state. When the power adapter charges the terminal, the magnitude of the detection current in the current detection circuit is detected. The detection circuit is connected in series between the output end of the power converter in the power adapter and the output port of the power adapter. The power converter is configured to convert the received voltage to a voltage adapted to the terminal being charged, thereby charging the terminal.

When charging is performed, the current outputted from the power converter and used for charging the terminal flows to the output port through the current detection circuit, and then flows to the terminal through the connection between the power line of the output port and the USB cable to charge the terminal. Herein, the current flowing through the current detection circuit is referred to as a detection current. The detection current is the current used by the power adapter to charge the terminal. The magnitude of the detection current indicates the magnitude of the current flows to the terminal when the power adapter is charging the terminal.

Herein, the current detection circuit may include a current detection resistor and an analog-to-digital converter. The analog-to-digital converter may be implemented by an analog-to-digital conversion module. The current detection resistor may be selected as desired. The resistance of the current detection resistor may be 5 mΩ to 15 mΩ. The value of the detection current of the current detection circuit is detected as follows: detecting, by the analog-to-digital converter in the current detection circuit, voltages at two ends of the current detection resistor in the current detection circuit to obtain a first voltage value and a second voltage value; obtaining a detection voltage value of the current detection resistor according to the first voltage value and the second voltage; and obtaining the value of the detection current according to the detection voltage value and the resistance of the current detection resistor.

Herein, the detecting, by the analog-to-digital converter in the current detection circuit, voltages at two ends of the current detection resistor in the current detection circuit to obtain the first voltage value and the second voltage value includes: collecting the voltages at the two ends of the current detection resistor by the analog-to-digital converter to obtain a first voltage and a second voltage; and performing an analog-to-digital conversion on the first voltage to obtain the first voltage value, and performing an analog-to-digital conversion on the second voltage to obtain the second voltage value.

A first port of the analog-to-digital converter is connected to one end of the current detection resistor and a second port of the analog-to-digital converter is connected to another end of the current detection resistor. The analog-to-digital converter collects voltages at the two ends of the current detection resistor through the first port and the second port. The voltage collected by the first port is the first voltage. The voltage collected by the second port is the second voltage. When the first voltage and the second voltage are collected by the analog-to-digital converter, the first voltage and the second voltage are converted to the first voltage value and the second voltage value respectively through analog-to-digital conversion, and the first voltage value and the second voltage value are transmitted to a power-adapted micro-control unit (MCU). The MCU is electrically connected to the current detection circuit to receive the first voltage value and the second voltage value of the current detection circuit. The MCU may be connected to only the analog-to-digital converter in the current detection circuit. After performing the analog-to-digital conversion on the first voltage and the second voltage, the analog-to-digital converter sends the MCU the first voltage value and the second voltage value obtained from the conversion.

The power adapter calculates the voltage value of the current detection resistor through the MCU. Herein, the voltage of the current detection resistor is referred to as the detection voltage. The detection voltage value of the current detection resistor is a difference between the first voltage value and the second voltage value.

A current output direction is from the output end of the power converter to the output port. Thus, the voltage value at the end of the current detection resistor connected to the output end of the power converter is greater than the voltage value at the end of the current detection resistor connected to the power line of the output port. Herein, the relationship between the first voltage value, the second voltage value and the voltage value at the end of the current detection resistor connected to the output end of the power converter, the voltage value at the end of the current detection resistor connected to the power line of the output port is not limited.

When the detection voltage value is obtained, the current flowing through the current detection resistor, that is, the value of the detection current of the current detection circuit, is calculated from the detection voltage value and the resistance of the current detection resistor. Here, the resistance of the current detection resistor is stored in the MCU in advance.

In step S102, the value of the detection current is transmitted to the terminal through the output port so that the terminal can determine, according to the detection current, whether charging is abnormal.

When the power adapter calculates the value of the detection current by the MCU, the value of the detection current is transmitted, by using the output port, to the terminal being charged. The value of the detection current is transmitted to the terminal through the output port as follows: transmitting the detection current in a form of data to the terminal by using a data negative signal line and a data positive signal line of the output port. Herein, the value of the detection current calculated by the MCU is a data signal. The data signal is transmitted, by using the data negative signal line and the data positive signal line used by the output port to connect to the USB cable as well as the USB cable, to the terminal connected to the power adapter.

When the terminal receives the value of the detection current, it is indicated that the terminal learns the magnitude of the current used by the power adapter to charge the terminal. In this case, it is determined, based on the received value of the detection current and the charging current value received by the terminal itself, whether the charging is abnormal.

In this embodiment of the present disclosure, the value of the detection current indicating the magnitude of the current transmitted to the terminal when the power adapter is charging the terminal is detected in the power adapter, and the value of the detection current is transmitted to the terminal so that the terminal can determine, based on the detection current, whether a charging abnormality such as a short circuit or an electric leakage occurs in the peripheral circuit of the terminal. Further, in the method for detecting a charging abnormality provided in this embodiment of the present disclosure, the current detection circuit is added between the power line of the output port of the power adapter and the output end of the power converter, and with the current detection circuit, the magnitude of the current value that the power adapter transmits to the terminal during the charging process is detected. This saves the trouble of adding additional hardware to the terminal. Thus, the charging abnormality of the terminal is detected in the case where the power adapter is modified in a simple way without increasing the production costs of the terminal.

### Embodiment two

A method for detecting a charging abnormality is provided in this embodiment of the present disclosure. The method is applicable to a terminal. As shown in FIG. 2, the method includes steps described below.

In step S201, a charging current value of a charging current received from a charging port is acquired when it is detected that the charging port is connected to a power adapter and is being charged.

When the terminal detects that the charging port is connected to the power adapter and is being charged and that the power adapter is used to charge the terminal, the magnitude of the charging current received by the terminal is detected. Herein, a charging module of the terminal may be used to detect the magnitude of the charging current received from a charger and to send a processor of the terminal a charging current value indicating the magnitude of the charging current.

In step S202, a value of a detection current transmitted from the power adapter is received.

When the terminal is connected to the power adapter and is being charged, the value of the detection current detected and transmitted by the charger is received while the charging current of the terminal itself is being detected. Herein, the value of the detection current transmitted by the charger is detected by a current detection circuit connected in series between the output end of a power converter and the power line of an output port. The value of the detection current indicates the magnitude of the current charging the terminal when the charger is charging the terminal.

After receiving the value of the detection current transmitted from the power adapter, the method further includes: comparing the charging current value with the value of the detection current; and determining that the charging current value does not match the value of the detection current when a current difference exists between the charging current value and the value of the detection current.

Herein, after the value of the detection current is received, the received value of the detection current is compared with the acquired charging current value to determine whether a current difference exists between the two. If a current difference exists, then the current used by the charger to charge the terminal is different from the current received by the charging module when the terminal is being charged, and the charging current value does not match the value of the detection current. If no current difference exists, then the current used by the charger to charge the terminal is equal to the current received by the charging module when the terminal is being charged, and the charging current value matches the value of the detection current.

Before acquiring the charging current value received from the charging port, the method further includes: setting a threshold of the current difference. The charging current value is determined to be not matched with the value of the detection current when the current difference is greater than the threshold of the current difference. In this case, if it is determined from the comparison between the charging current value and the value of the detection current that a current difference exists between the charging current value and the value of the detection current, it is further determined whether the current difference is below the threshold of the current difference. When the current difference is greater than the threshold of the current difference, it is determined that the charging current value does not match the value of the detection current. When the current difference is not greater than the threshold of the current difference and is not beyond the threshold of the current difference, it is determined that the charging current value matches the value of the detection current.

In step S203, when the charging current value does not match the value of the detection current, it is determined that charging is abnormal.

If the terminal determines that the charging current value does not match the value of the detection current, then the current received by the charging module of the terminal, that is, the current received from the output end of the charging port is less than the current used by the power adapter to charge the terminal. For example, the current received at the input end of the charging port is less than the current outputted at the output end of the charging port. Here, with respect to the current charging direction, when the power adapter charges the terminal, the end of the charging port connected to the power adapter is the input end and the end of the charging port connected to the charging module inside the terminal is the output end.

After the terminal determines that the charging is abnormal, the method may further include triggering a charging stop instruction to instruct to stop charging. Here, when it is determined that the charging is abnormal, it is determined that a short circuit or an electric leakage occurs in a peripheral circuit such as a USB connector, an ESD protection circuit and a surge protection circuit, the charging is stopped, and an alarm message is sent to a user to instruct the user to take emergency measures.

In this embodiment of the present disclosure, the execution sequence of the step of acquiring the charging current value and the step of receiving the value of the detection current transmitted by the power adapter is not limited.

With the method for detecting a charging abnormality provided in this embodiment of the present disclosure, in the case where the terminal acquires the magnitude of the current used by the power adapter to charge the terminal, the terminal compares this current value with the magnitude of the charging current of the terminal itself and accurately detects whether a short circuit or an electric leakage occurs in the current peripheral circuit such as a USB connector, an ESD protection circuit and a surge protection circuit.

### Example three

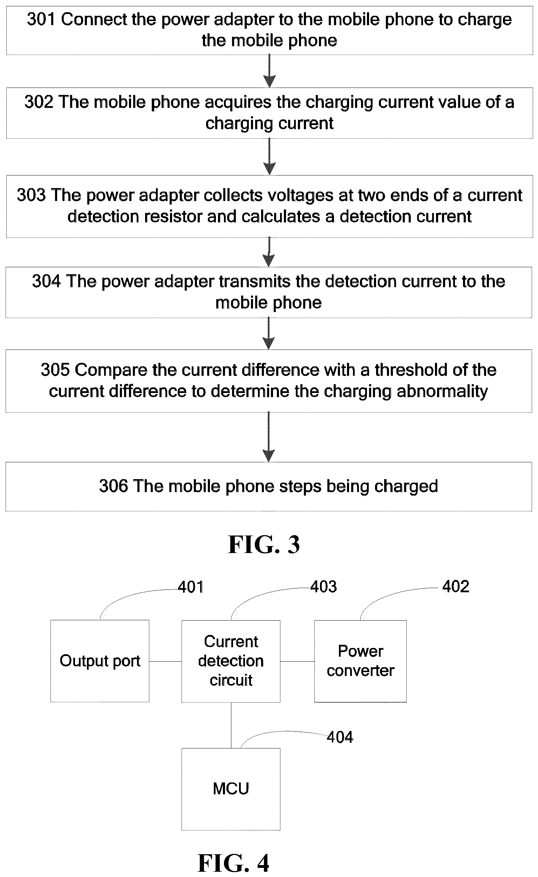

In this embodiment of the present disclosure, a method for detecting a charging abnormality is described in conjunction with an application scenario in which a mobile phone is charged by a power adapter. As shown in FIG. 3, the method includes steps described below.

In step S301, the power adapter is connected to the mobile phone to charge the mobile phone.

One end of a USB cable is plugged into the power adapter, and the adapter is powered on. The other end of the USB cable is plugged into the mobile phone. Herein, after detecting that the adapter is plugged, the mobile phone completes handshake with the power adapter, and then charging is started. In this case, the power adapter detects that its output port is connected to the terminal and is in a charging state, and the mobile phone detects that its charging port is connected to the power adapter and is being charged.

In step S302, the mobile phone acquires the charging current value of a charging current.

The mobile phone detects the charging current value I_charger of the mobile phone by a charging management module.

In step S303, the power adapter collects voltages at two ends of a current detection resistor and calculates a detection current.

The adapter uses an analog-to-digital converter (ADC) to detect voltages at the two ends of the current detection resistor inside the power adapter, to perform an analog-to-digital conversion on the detected voltages to obtain voltage values Va and Vb at the two ends, and then to transmit Va and Vb to an MCU. After acquiring the voltage values Va and Vb at the two ends of the current detection resistor, the MCU calculates the detection current flowing through the current detection resistor, that is, the output current I_BUS of the adapter, where I_BUS = (Va - Vb)/R.

In step S304, the power adapter transmits the detection current to the mobile phone.

After acquiring the value of the detection current (the output current of the adapter) I_BUS, the MCU of the power adapter transmits I_BUS in the form of data to the terminal through USB. After receiving the value of the detection current outputted by the power adapter, the mobile phone calculates the current difference I_leakage between the charging current value of a charging module and the value of the detection current (I_leakage = I_BUS-I_charger). Herein, the current difference I_leakage is the magnitude of the leakage current of a peripheral circuit.

In step S305, the current difference is compared with a threshold of the current difference to determine the charging abnormality.

If it is determined that the I_leakage is greater than the threshold of the current difference (that is, the maximum allowable leakage current of all peripheral circuits including the USB connector, ESD protection circuit and surge protection circuit of the charging circuit of the mobile phone), then a short circuit or an electric leakage occurs and the charging is abnormal; if it is determined that the I_leakage is equal to or less than the threshold of the current difference, then the charging is normal.

In step S306, the mobile phone is stopped from being charged.

After the charge abnormality such as the short circuit or the electric leakage is detected, the charging is stopped, and an alarm message is sent to a user to instruct the user to take emergency measures.

### Embodiment four

To implement the method for detecting a charging abnormality provided in embodiment one, a power adapter is provided in this embodiment of the present disclosure. As shown in FIG. 4, the power adapter includes an output port 401, a power converter 402, a current detection circuit 403 and a micro-control unit (MCU) 404. The current detection circuit 403 is connected in series between a power line of the output port 401 and an output end of the power converter 402. The MCU404 is electrically connected to the current detection circuit 403.

Herein, when the output port 401 is connected to a terminal and is in a charging state, the MCU404 detects a value of the detection current in the current detection circuit 403 and transmits the value of the detection current to the terminal through the output port 401 to allow the terminal to determine, according to the detection current, whether charging is abnormal.

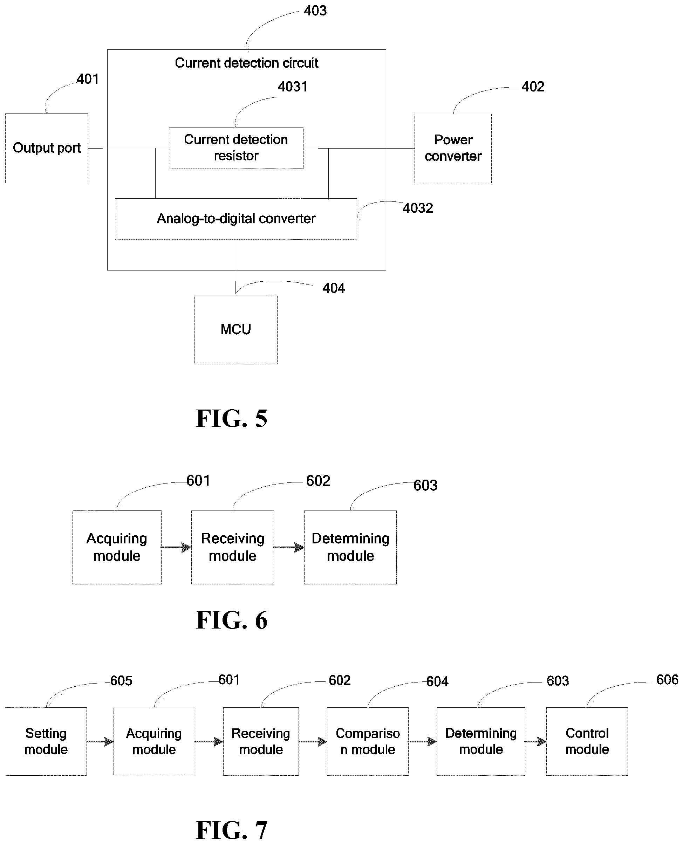

As shown in FIG. 5, the current detection circuit 403 includes a current detection resistor 4031 and an analog-to-digital converter 4032. A first port of the analog-to-digital converter 4032 is connected to one end of the current detection resistor 4031 and a second port of the analog-to-digital converter 4032 is connected to another end of the current detection resistor 4031.

The analog-to-digital converter 4032 is configured to collect voltage values at the two ends of the current detection resistor 4031 through the first port and the second port to obtain a first voltage value and a second voltage value.

The MCU404 is configured to obtain a detection voltage value of the current detection resistor according to the first voltage value and the second voltage; and obtain the value of the detection current according to the detection voltage value and a resistance of the current detection resistor 4031.

The analog-to-digital converter 4032 is configured to collect the voltages at the two ends of the current detection resistor 4031 to obtain a first voltage and a second voltage; and perform an analog-to-digital conversion on the first voltage to obtain the first voltage value, perform an analog-to-digital conversion on the second voltage to obtain the second voltage value, and transmit the first voltage value and the second voltage value to the MCU404.

Herein, the MCU404 is connected to a data negative signal line and a data positive signal line of the output port 401.

The MCU404 transmits the detection current in a form of data to the terminal through the data negative signal line and the data positive signal line.

### Embodiment five

To implement the method for detecting a charging abnormality provided in the preceding embodiment two, a device for detecting a charging abnormality is provided in this embodiment of the present disclosure. The device is applicable to a terminal. As shown in FIG. 6, the device includes an acquiring module 601, a receiving module 602 and a determining module 603.

The acquiring module 601 is configured to acquire a charging current value of a charging current received from a charging port when it is detected that the charging port is connected to a power adapter and is being charged.

The receiving module 602 is configured to receive a value of a detection current transmitted from the power adapter.

The determining module 603 is configured to determine that charging is abnormal when the charging current value does not match the value of the detection current.

As shown in FIG. 7, the device may further include a comparison module 604 configured to: compare the charging current value with the value of the detection current; and determine that the charging current value does not match the value of the detection current when a current difference exists between the charging current value and the value of the detection current.

As shown in FIG. 7, the device further includes a setting module 605 configured to set a threshold of the current difference.

The comparison module is configured to determine that the charging current value does not match the value of the detection current as follows:
determining that the charging current value does not match the value of the detection current when the current difference is greater than the threshold of the current difference.

As shown in FIG. 7, the device may further include a control module 606 configured to trigger, after it is determined that the charging is abnormal, a charging stop instruction to instruct to stop charging.

### Embodiment six

To implement the preceding method, a terminal is provided in this embodiment of the present disclosure. The terminal includes a charging port, a processor and a memory. The memory has computer-executable codes. The processor is configured to perform, according to the computer-executable codes, the following operations: acquiring a charging current value of a charging current received from a charging port when it is detected that the charging port is connected to a power adapter and is being charged; receiving a value of a detection current transmitted from the power adapter; and determining that charging is abnormal when the charging current value does not match the value of the detection current.

The processor is further configured to perform the following operations:
comparing the charging current value with the value of the detection current; and determining that the charging current value does not match the value of the detection current when a current difference exists between the charging current value and the value of the detection current.

Herein, before the charging current value of the charging current received from the charging port is acquired, a threshold of the current difference is set. Correspondingly, determining that the charging current value does not match the value of the detection current includes:
determining that the charging current value does not match the value of the detection current when the current difference is greater than the threshold of the current difference.

After it is determined that the charging is abnormal, the processor is further configured to trigger a charging stop instruction to instruct to stop charging.

### Embodiment seven

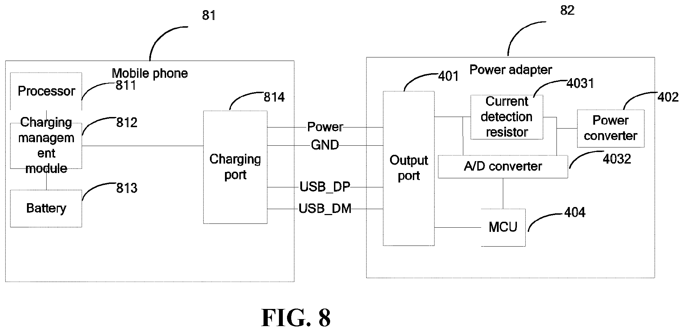

A system for detecting a charging abnormality is provided in this embodiment of the present disclosure. As shown in FIG. 8, the system includes a mobile phone 81 and a power adapter 82. The mobile phone 81 as a charged device is provided with a charging management module 812. The charging management module 812 is connected to a battery 813. A current (I_CHARGER) and a voltage (V_BUS) flowing from the power adapter 82 to the charging management module 812 after passing through a data line may be monitored. Herein, a current detection resistor R4031 is connected in series in a power line of an output port 401 in the power adapter 82. A self-contained ADC module 4032 may collect voltages Va and Vb at two ends of the current detection resistor R4031. After an MCU404 in the power adapter 82 acquires Va and Vb, the output current value of the power adapter 82 may be calculated using the formula: I_BUS = (Va-Vb)/R. The power adapter 82 transmits the I_BUS data to the mobile phone 81 via a data negative signal line (USB DM) and a data positive signal line (USB DP) of a USB cable by using the MCU404. After receiving I_BUS via a charging port 814, the mobile phone 81 compares I_BUS with I_CHARGER by using a processor 811, that is, I_LEAKAGE = I_BUS-I_CHARGER. If I LEAKAGE exceeds a threshold of the current difference, such as 100 mA, then it can be determined that a short circuit or an electric leakage occurs in a charging peripheral circuit. In this case, the charging is stopped, and an alarm message is sent to a user to instruct the user to take emergency measures.

A computer-readable storage medium is provided in an embodiment of the present disclosure. The storage medium is configured to store computer-executable instructions. When the computer-executable instructions are executed by a processor, the preceding method for detecting a charging abnormality is implemented.

The present application is described with reference to flowcharts and/or block diagrams of the method, device (system) and computer program product according to embodiments of the present disclosure. It is to be understood that the computer program instructions can be used to implement each flow and/or block in the flowcharts and/or block diagrams and a combination of flows and/or blocks in the flowcharts and/or block diagrams. These computer program instructions can be provided to a processor of a general purpose computer, special purpose computer, embedded processor, or another programmable data processing device to produce a machine, so as to enable instructions executed by a processor of a computer or another programmable data processing device to generate an device for implementing the functions specified in one or more flows in the flowcharts and/or one or more blocks in the block diagrams.

These computer program instructions can also be stored in a computer-readable memory that can direct a computer or another programmable data processing device to operate in a particular manner, so that the instructions stored in the computer-readable memory produce an article of manufacture including an instruction device. The instruction device implements the functions specified in one or more flows in the flowcharts and/or one or more blocks in the block diagrams.

These computer program instructions can also be loaded onto a computer or another programmable data processing device, so that a series of operating steps are performed on a computer or another programmable device, and the instructions executed on the computer or another programmable device provide steps for implementing the functions specified in one or more flows in the flowcharts and/or one or more blocks in the block diagrams.

The preceding are merely embodiments of the present disclosure and are not intended to limit the scope of the present application.

### INDUSTRIAL APPLICABILITY

In embodiments of the present disclosure, when the power adapter is in the charging state, the magnitude of the current value transmitted by the power adapter to the terminal is determined according to the value of the detection current of the current detection circuit connected between the output end of the power converter and the power line of the output port, and whether the terminal is in a charging abnormality state is determined according to the magnitude of the current value. When the terminal receives the value of the detection current and determines that the value of the detection current does not match the magnitude of the charging current, it is determined that the terminal is in the charging abnormality state. In this solution, the charging abnormality of the terminal is detected without modification of hardware of the terminal, avoiding further faults and losses arising from a charging abnormality such as a power leakage after a USB connector or the like is short-circuited.

## Claims

1. A method for detecting a charging abnormality, comprises:
detecting a value of a detection current in a current detection circuit when it is detected that an output port is connected to a terminal and is in a charging state, wherein the current detection circuit is connected in series between an output end of a power converter and a power line of the output port; and
transmitting the value of the detection current to the terminal through the output port to allow the terminal to determine, according to the detection current, whether charging is abnormal.

2. The method of claim 1, wherein the detecting a value of a detection current in a current detection circuit comprises:
detecting voltages at two ends of a current detection resistor in the current detection circuit by an analog-to-digital converter in the current detection circuit to obtain a first voltage value and a second voltage value;
obtaining a detection voltage value of the current detection resistor according to the first voltage value and the second voltage; and
obtaining the value of the detection current according to the detection voltage value and a resistance of the current detection resistor.

3. The method of claim 2, wherein the detecting voltages at two ends of a current detection resistor in the current detection circuit by an analog-to-digital converter in the current detection circuit to obtain a first voltage value and a second voltage value comprises:
collecting the voltages at the two ends of the current detection resistor by the analog-to-digital converter to obtain a first voltage and a second voltage; and
performing an analog-to-digital conversion on the first voltage to obtain the first voltage value, and performing an analog-to-digital conversion on the second voltage to obtain the second voltage value.

4. The method of claim 1, wherein the transmitting the value of the detection current to the terminal through the output port comprises:
transmitting the detection current in a form of data to the terminal by a data negative signal line and a data positive signal line of the output port.

5. A method for detecting a charging abnormality, comprises:
acquiring a charging current value received from a charging port when it is detected that the charging port is connected to a power adapter and is being charged;
receiving a value of a detection current transmitted from the power adapter; and
determining that charging is abnormal when the charging current value does not match the value of the detection current.

6. The method of claim 5, wherein after the receiving a value of a detection current transmitted from the power adapter, the method further comprises:
comparing the charging current value with the value of the detection current; and
determining that the charging current value does not match the value of the detection current when a current difference exists between the charging current value and the value of the detection current.

7. The method of claim 6, wherein before the acquiring a charging current value received from a charging port, the method further comprises: setting a threshold of the current difference;
wherein the determining that the charging current value does not match the value of the detection current comprises: determining that the charging current value does not match the value of the detection current when the current difference is greater than the threshold of the current difference.

8. The method of claim 5, wherein after the determining that charging is abnormal, the method further comprises:
triggering a charging stop instruction to instruct to stop being charged.

9. A power adapter, comprising an output port, a power converter, a current detection circuit and a micro-control unit (MCU), wherein the current detection circuit is connected in series between a power line of the output port and an output end of the power converter, and the MCU is electrically connected to the current detection circuit.

10. The power adapter of claim 9, wherein when the output port is connected to a terminal and is in a charging state, the MCU is configured to detect a value of a detection current in the current detection circuit, and transmit the value of the detection current to the terminal through the output port to allow the terminal to determine, according to the detection current, whether charging is abnormal.

11. The power adapter of claim 9, wherein the current detection circuit comprises a current detection resistor and an analog-to-digital converter, wherein a first port of the analog-to-digital converter is connected to one end of the current detection resistor and a second port of the analog-to-digital converter is connected to another end of the current detection resistor.

12. The power adapter of claim 11, wherein the analog-to-digital converter is configured to collect voltage values at the two ends of the current detection resistor by the first port and the second port to obtain a first voltage value and a second voltage value; and
the MCU is configured to obtain a detection voltage value of the current detection resistor according to the first voltage value and the second voltage value; and obtain the value of the detection current according to the detection voltage value and a resistance of the current detection resistor.

13. The power adapter of claim 12, wherein the analog-to-digital converter is further configured to:
collect the voltages at the two ends of the current detection resistor to obtain a first voltage and a second voltage; and
perform an analog-to-digital conversion on the first voltage to obtain the first voltage value, perform an analog-to-digital conversion on the second voltage to obtain the second voltage value, and transmit the first voltage value and the second voltage value to the MCU.

14. The power adapter of claim 10, wherein the MCU is connected to a data negative signal line and a data positive signal line of the output port; and
the MCU is further configured to transmit the detection current in a form of data to the terminal by the data negative signal line and the data positive signal line.

15. A device for detecting a current abnormality, comprising: an acquiring module, a receiving module and a determining module, wherein
the acquiring module is configured to acquire a charging current value received from a charging port when it is detected that the charging port is connected to a power adapter and is being charged;
the receiving module is configured to receive a value of a detection current transmitted from the power adapter; and
the determining module is configured to determine that charging is abnormal when the charging current value does not match the value of the detection current.

16. The device of claim 15, further comprising a comparison module configured to:
compare the charging current value with the value of the detection current; and
determine that the charging current value does not match the value of the detection current when a current difference exists between the charging current value and the value of the detection current.

17. The device of claim 16, further comprising a setting module configured to set a threshold of the current difference, wherein the comparison module is further configured to:
determine that the charging current value does not match the value of the detection current when the current difference is greater than the threshold of the current difference.

18. The device of claim 15, further comprising: a control module, configured to trigger, after it is determined that the charging is abnormal, a charging stop instruction to instruct to stop being charged.
